(19)

Europäisches
Patentamt
European
Patent Office
Office européen
des brevets

(11)  **EP 2 337 063 B1**

(12)  **EUROPEAN PATENT SPECIFICATION**

(45) Date of publication and mention
of the grant of the patent:
**23.10.2013 Bulletin 2013/43**

(21) Application number: **09179745.6**

(22) Date of filing: **17.12.2009**

(51) Int Cl.:
*H01L 49/02* (2006.01)          *H01L 21/02* (2006.01)
*H01F 41/04* (2006.01)          *H01L 23/522* (2006.01)
*H01F 17/00* (2006.01)          *H01L 23/64* (2006.01)

(54) **On chip integrated inductor and manufacturing method therefor**

On-Chip Induktivität und Herstellungsverfahren dafür

Inducteur intégré sur puce et son procédé de fabrication

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**22.06.2011 Bulletin 2011/25**

(73) Proprietor: **NXP B.V.
5656 AG Eindhoven (NL)**

(72) Inventors:
• **Golubovic, Dusan
Redhill, Surrey RH1 1DL (GB)**
• **Fotopoulou, Korina
Redhill, Surrey RH1 1DL (GB)**

(74) Representative: **Burton, Nick et al
NXP Semiconductors
Intellectual Property and Licensing
Red Central
60 High Street
Redhill, Surrey RH1 1SH (GB)**

(56) References cited:
**US-A1- 2004 263 310      US-A1- 2005 133 924
US-B1- 6 396 122      US-B1- 6 441 715**

• **PINGSHAN WANG ET AL: "Tailoring High-
Frequency Properties of Permalloy Films by
Submicrometer Patterning" IEEE
TRANSACTIONS ON MAGNETICS, IEEE
SERVICE CENTER, NEW YORK, NY, US, vol. 42,
no. 1, 1 January 2009 (2009-01-01), pages 71-74,
XP011243438 ISSN: 0018-9464**
• **HIROHATA A ET AL: "Magnetic Domain Evolution
in Permalloy Mesoscopic Dots" IEEE
TRANSACTIONS ON MAGNETICS, IEEE
SERVICE CENTER, NEW YORK, NY, US LNKD-
DOI:10.1109/20.800697, vol. 35, no. 5, 1
September 1999 (1999-09-01), pages 3886-3888,
XP011087509 ISSN: 0018-9464**
• **GAMET E ET AL: "Simulation of the contribution
of magnetic films on planar inductors
characteristics" JOURNAL OF MAGNETISM AND
MAGNETIC MATERIALS, ELSEVIER SCIENCE
PUBLISHERS, AMSTERDAM, NL, vol. 288, 1
March 2005 (2005-03-01), pages 121-129,
XP025364520 ISSN: 0304-8853 [retrieved on
2005-03-01]**

EP 2 337 063 B1

**Description**

The invention relates to an inductor integrated in a semiconductor chip and a method for its manufacture.

Inductors are important elements of integrated circuits in a wide and diverse range of applications. For example, inductors are used in signal processing circuits such as high-pass filters, resonant tank circuits and Butterworth filters in communication systems. Additional applications include impedance matching network topologies in radio frequency (RF) transceiver circuits. Efficient integrated transformers for dc/dc converters in hybrid electric vehicles also require integrated micro-coils. In inductive power transfer systems for radio frequency identification (RFID) devices and embedded biomedical implants integrated coils are key elements. Micro electromechanical systems (MEMS) resonators and magnetic sensors also require high quality integrated inductors.

Ideally, inductors should be integrated with system electronics at a system design level. However, traditionally inductors are large auxiliary components which are very difficult to miniaturise. Attempts have been made to eliminate inductors in communication systems by simulating their action by active element. However, this approach can be unsuccessful as it introduces more parasitics and often generates more noise than actual inductors.

When unable to eliminate inductors designers use integrated two-dimensional spiral inductors that are fabricated on the same substrate as the integrated circuits to which they are coupled. Although such inductors can be manufactured by conventional integrated circuit manufacturing, they typically suffer from low inductance, low quality factor and typically consume a large share of surface area.

It would therefore be advantageous to integrate the manufacturing of an inductor with the manufacture of an integrated circuit in an improved way. There is a particular need to fabricate inductors for high frequency applications.

Integrated circuit manufacture is a very advanced technology. The process steps can be divided into the front end of line (FEOL) and the back end of line (BEOL). The front end of line is the set of process steps up to the first metallization layer, and the back end of line is the remainder of the steps. The front end of line manufactures a wide variety of active and passive semiconductor devices on a chip; the back end of line is used to manufacture interconnects and contacts. Increasingly, more than one level of interconnect may be used.

US 6441715 describes a method for fabricating conductors and transformers on integrated circuits. A magnetic material is formed on the semiconductor substrate. The magnetic material comprises a suspension of magnetic material in an insulator. A metal film is formed that forms at least one coil around the magnetic material forming an inductor structure. Two adjacent coils can be linked with the magnetic material to form a transformer.

According to the invention, there is provided a method of making an inductor on a chip according to claim 1.

The invention exploits the properties of micrometre or sub-micrometre magnetic elements. They have a higher ferromagnetic resonant frequency compared with their bulk counterparts, so they can be used in a broader frequency range, typically extending into the GHz region. The magnetic permeability is increased compared to the bulk values, and the dissipative part of the permeability reduced. Noise is also reduced.

For these reason, very small magnetic elements are very well suited to providing enhanced inductances on a chip.

The inductances can easily be manufactured in a way compatible with conventional back end processing. There is no need for any changes to manufacture up to the metallization layer used to form the loop.

The invention also relates to a semiconductor chip with an inductor according to claim 8.

For a better understanding of the invention, embodiments will be described, purely by way of example, with reference to the accompanying drawings, in which

Figure 1 shows in side view a first stage in the manufacture of an integrated inductor;
Figure 2 shows in side view a second stage in the manufacture of the integrated inductor;
Figure 3. shows in side view a third stage in the manufacture of the integrated inductor;
Figure 4 shows in top view the stage shown in Figure 3; and
Figure 5 shows a top view of an alternative layout, and
Figure 6 shows a top view of an embodiment.

The figures are schematic and not to scale. In particular, the vertical direction in the side views is greatly exaggerated.

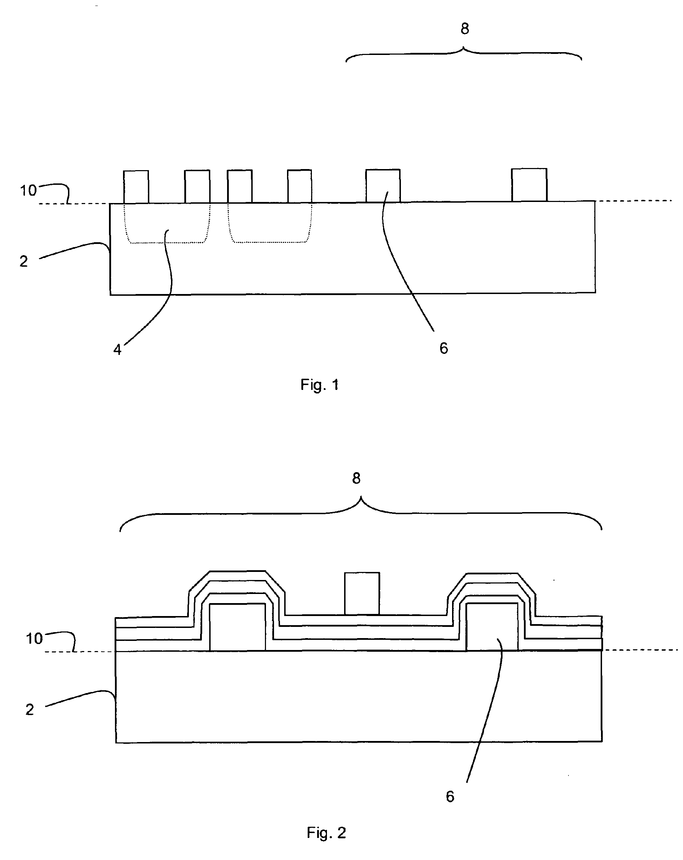

Referring to Figure 1, an integrated circuit 2 is manufactured to the end of the FEOL to have a plurality of semiconductor devices 4 and a metallization layer 6. In the example, the metallization layer 6 is of Al.

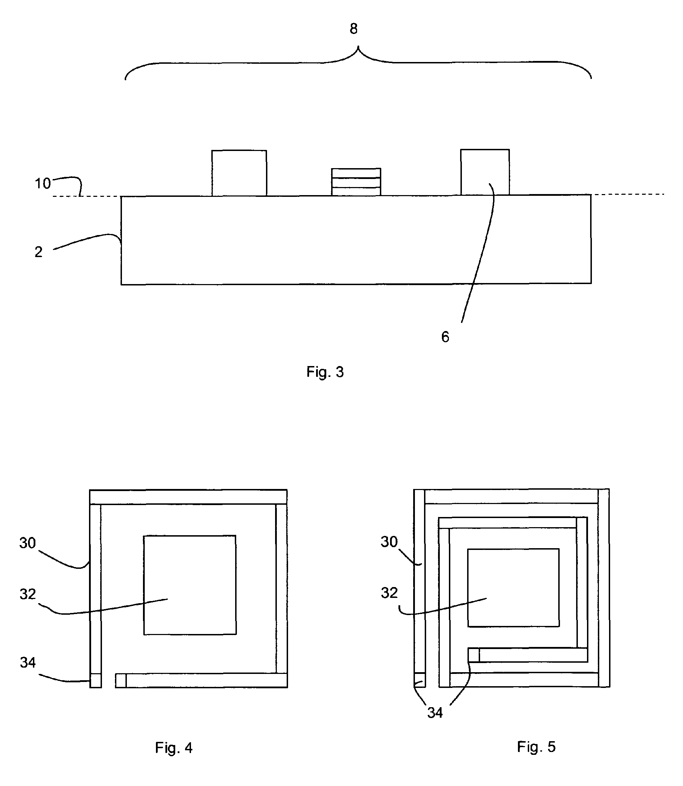

The metallization layer is patterned as usual in regions of the integrated circuit 2 with a semiconductor device and in the region 8 for forming an inductor the metallization layer 6 is patterned to form a loop 30 as illustrated in Figure 3. The loop is in the plane 10 of the integrated circuit, the plane being indicated in Figure 1.

Then, a refractory metal layer 12 is deposited over the full surface of the semiconductor device, followed by a magnetic thin film 14 and a protection layer 16. The functions of these layers are described below. The refractory metal layer 12 and magnetic thin film 14 may in particular be deposited by a sputtering process.

A photoresist layer 18 is then deposited and patterned to leave photoresist only on a magnetic element 32 at the centre of the loop, resulting in the arrangement shown in Figure 1.

The photoresist is then used as a mask in a Chlorine based reactive ion etch process which leaves the triple layer structure of refractory metal layer 12, magnetic thin film 14 and protection layer 16 in the magnetic element 32 in the centre of the loop. The photoresist is then removed.

The size of the magnetic element 32 is chosen to be small, to allow the loop 30 and magnetic core constituted by the magnetic element of the magnetic film to have desirable properties, in particular to operate at high frequencies. The physical considerations behind this will now be discussed.

It is known that when a magnetic material is subjected to a magnetic field oscillating at frequency $\omega$, its response is described by a complex magnetic permeability $\chi(\omega) = \chi_M(\omega) - j\chi_D(\omega)$ where j is $\sqrt{-1}$. $\chi_M(\omega)$ governs the magnetic response of the medium, whereas $\chi_D(\omega)$ shows the losses at a frequency $\omega$, (when $\omega \to 0$ then $\chi_D(\omega) \to 0$.

In case of bulk magnetic materials, the complex permeability $\chi(\omega)$ is determined by the intrinsic material properties. On the other hand, the complex permeability of thin magnetic films already significantly differs compared to a bulk specimen with the same composition. Furthermore, by introducing lateral dimensions constraints the properties of a magnetic material can be substantially altered compared to the original bulk material, as well as to thin magnetic films. These changes in the magnetic properties come about due to a substantial modification in magnetic ordering caused by reduced dimensionality.

The general inductive properties of thin current loops are known from textbooks such as S. Ramo, J. R. Whinnery and T. VanDuzer, Fields and Waves in Communication Electronics, John Wiley & Sons, Inc. Third Edition, 1994 and W. R. Smythe, Static and Dynamic Electricity, McGraw-Hill Book Company, Second Edition, 1950.

Integrating a suitable core of magnetic film into the loop can act as a flux-amplifying component., By reducing flux leakage the effective inductance of the coil will increase while the unwanted Ohmic losses will be reduced achieving a high quality factor Q defined as:

$$Q(\omega) = \frac{\omega L}{R}$$

A suitable magnetic material used in on-chip RF integrated inductors must accordingly exhibit high permeability and low magnetic loss in high-frequency range as well as process compatibility with IC processes. Relative permeability ($\mu_r$) and specific resistivity p of a magnetic material are the key parameters. Due to losses in the ferromagnetic material the intrinsic permeability is a complex quantity with a clear frequency dependence defined as:

$$\mu_r(j\omega) = \mu_r^R - j\mu_r^I$$

where $\mu_r^R$ is the real component of the series complex permeability, which represents the magnetic performance and consequently contributes to the inductance L of the integrated coil, while $\mu_r^I$ is the imaginary part of the complex permeability and determines the magnetic loss of the material.

At low frequencies for typical ferrite materials $\mu_r^R$ is much larger than $\mu_r^I$. For conventional ferrite cores used in transformer applications such as pot core and cylindrical cores it is true that the magnetic losses will increase at high frequencies in the GHz region as ferrite shows a low ferromagnetic resonance frequency $f_M$ which is hard to exceed 800MHz.

Here it needs to be emphasized that for bulk materials both the real and imaginary parts of the complex permeability, as well as ferromagnetic resonance frequency, are governed solely by the material composition. However, when the dimensions of a magnetic structure (thickness, lateral dimensions) become comparable to the average ferromagnetic domain size, the complex permeability becomes strongly dependent on the size, as well. As a result, the size can be used as a efficient means to tailor the relevant properties of a magnetic element.

The high frequency characteristics of permalloy (NiFe) and FeCo thin magnetic films have been investigated by N X Sun et al, IEEE Tran Magnetic. p.146, volume 38, number 1, 2002. The -3dB cut-off frequency is 1.5 GHz. This analysis has been performed on a multidomain thin film, where magnetic domains are present and magnetic switching occurs through Neel wall rotation. Neel domain walls are in-plane of a thin magnetic film, unlike bulk domain walls (Bloch walls), where magnetization switching occurs out of the film's plane. The presence of Neel walls adds a dumping-like component to the dynamics of the system and limits its cut-off frequency.

As opposed to multi-domain thin magnetic films, magnetic thin films with (sub-) micrometre lateral dimensions are in a single domain state, as formation of a domain wall is energetically less favourable than stray magnetic fields associated with the single domain state. For example, L Giovannini et al, Phys Rev. B, volume 70, 172404, 2004, study the dynamic behaviour of FeNi (permalloy) magnetic disks has been studied. In contrast to the multi-domain films these disks are in the single-domain state, which implies that their dynamics is determined only by spin dynamics and its interactions with lattice, as well as Zeeman and many-body spin and electron interactions. As a result, the cut-off frequency increases dramatically to above 10GHz.

A significant increase in the cut-off frequency by means of reducing only the lateral dimensions of ferromagnetic thin films has been demonstrated in P. Wang et al. IEEE Tran Magnetics, volume 45, no 1, pp 71-74 (2009), wherein ferromagnetic resonance frequency of a thin permalloy film has been increased from about 8 GHz to 11.5 GHz just by reducing its width from 550 nm to 240 nm.

The inventors have realised that as a result thin-film soft ferromagnetic Materials and in particular thin soft magnetic films with (sub - ) micrometre lateral dimensions and hence a single magnetic domain (or only a few domains) are suitable for operation in a broad range of frequencies. Thus; the lateral dimension of the or each magnetic element (32) is chosen such that each magnetic element only has a few domains, or preferable exactly one single domain.

The concept works with a wide variety of magnetic materials. Thin film magnetic materials that combine high permeability, good thermal stability, high saturation magnetization, high resistivity, good high-frequency properties, and are silicon process compatible such as are suitable for high frequency inductors.

For ease of processing, relatively well known materials such $Fe_xNi_{1-x}$ alloy, known as permalloy, may be brought into a single domain state, which allows for high frequency operationm, with thin films of up to 100 nm thickness and lateral dimensions in sub-micrometre regime. As abovementioned, it is possible to exceed 10 GHz -3 dB frequency. Cobalt is a possible alternative.

More advanced materials may be used, for example CoZrTa and Ni- Zn (- Co) . These allow for a wider range of possibilities. In particular, it possible using a variety of materials to adjust the properties far more- permalloy is generally used in a form with 80% Ni and 20% Fe and so the bulk properties are fixed. By using ternary materials such as CoZrTa alloy there is a much greater flexibility in the exact alloy composition which allows the exact properties to be tailored to meet requirements. In particular, it may be possible to adjust both the real and imagineary parts of the magnetic permeability with suitable choices of materials, which can in particular allow the degree of loss to be controlled. The choice of such materials may also allow the temperature dependence to be controlled.

Accordingly it is possible to significantly improve $f_M$ and reduce $\mu_r^I$ with only slightly compromising the overall magnetic permeability of the material $\mu_r$

The smaller laterally constrained cores used in the present invention have a number of advantages over bulk materials. Most importantly, the ferromagnetic resonant frequency $f_M$ is increased allowing the inductor core to operate into the GHz range. Further, however, the modulus of the magnetic permeability $\chi(\omega)$ is itself increased, and the dissipative part of the permeability $\chi_D(\omega)$ *is* decreased.

The noise contribution from Barkhausen noise is also significantly reduced.

For example, a planar 1 $\mu$m square central area 32 of magnetic material within and surrounded by a loop with 0.3 $\mu$m wide metal lines raises the inductance of the loop from about 1 pH to 0.1 nH, a factor of a hundred. This greatly reduces the area to provide inductances on chip with the improved properties discussed above.

The use of the refractory metal layer 12 under the magnetic region has a number of effects. Firstly, it improves the adhesion of the magnetic film to the inter-metal dielectric which forms the surface of the chip 2. Secondly, it acts as a diffusion barrier which may be important if the magnetic film contains fast diffusers, for example in an alloy. Thirdly, the refractory metal layer 12 may set the texture of the subsequently deposited films, which may be used to tailor the magnetic properties. However, the refractory metal layer 12 is not absolutely essential to the operation of the invention and may be omitted if not required.

The protection layer 16 simply protects the magnetic film. For experimental laboratory purposes gold may be used. For commercial integrated circuit manufacture gold is generally not allowed so standard BEOL refractory metals (compounds) such as TiN or TaN may be used.

The term "loop" does not imply that the loop needs to be a closed loop. See the possible alternative arrangements in Figures 4 and 5. Note that the loop is not a complete ring since the loop needs to have contacts 34 formed at the ends of it. The loop can be less than a full turn (Figure 4) or more than a full turn (Figure 5).

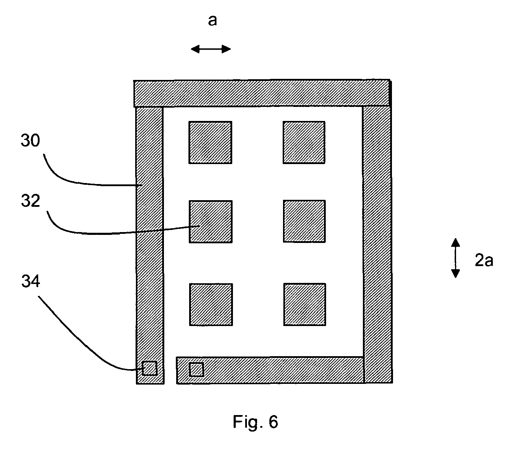

An embodiment is shown in Figure 6. In order to ensure that a magnetic material used is in single domain state, instead of one magnetic element a plurality of magnetic elements is used as shown in Figure 6. Assuming the lateral dimensions of the squares shown are a, the separation between them should be kept at 2a (or more) so that there is not electromagnetic interaction between them and anti-ferromagnetic ordering sets in. The same applies for circular magnetic elements with radius r, the distance should be 2r.

By using a plurality of magnetic elements the benefits of small magnetic element size can be used even for loops of larger size and larger inductance.

## Claims

1. A method of making an inductor on a chip, comprising:

manufacturing an integrated circuit chip (2) on a substrate to a step with a metallization layer (6) formed, the integrated circuit chip (2) including a plurality of semiconductor devices (4);
defining a loop (30) extending in the plane (10) of the chip in the metallization layer (6);
depositing a layer of magnetic material (14);
depositing and patterning resist (18) over the layer of magnetic material to define the area of at least one magnetic element (32) within the loop;
etching to remove the magnetic material (14) except where protected by the resist; and
removing the resist to leave the loop (30) in the metallization layer (6) around at least one magnetic element (32) of the magnetic material (14), the or each magnetic element (32) having lateral dimensions such that it includes no more than five magnetic domains, wherein the steps of depositing and patterning resist (18) and etching define a plurality of magnetic elements (32) within the loop (10), the magnetic elements being spaced apart to have a gap between adjacent elements of at least double the largest lateral dimension of each magnetic element.

2. A method according to claim 1 wherein the or each magnetic element (32) includes a single magnetic domain.

3. A method according to claim 1 or 2 wherein the lateral dimension of the or each magnetic element (32) is no more than 1 μm.

4. A method according to any preceding claim, further comprising depositing a refractory metal layer (12) over the surface of the chip after the step of defining a loop (30) and before the step of depositing a layer of magnetic material (14), wherein the step of etching also removes the refractory metal (12) except where protected by the resist (18).

5. A method according to any preceding claim, further comprising depositing a protection layer (16) over the layer of magnetic material (14), wherein the step of etching also removes the protection layer (16) except where protected by the resist.

6. A method according to any preceding claim, wherein the step of etching uses a dry chlorine etch.

7. A method according to any preceding claim wherein the magnetic material is an alloy of Fe and Ni.

8. A semiconductor chip, comprising:

a plurality of semiconductor devices (4) formed on a substrate;

a metallization layer (6) over the substrate, the metallization layer including at least one loop (30) forming an inductor;
a magnetic material (14) formed as at least one magnetic element (32) within the loop, the magnetic element having lateral dimensions such that it includes no more than five magnetic domains,
and including a plurality of magnetic elements (32) within the loop (10), the magnetic elements being spaced apart to have a gap between adjacent elements of at least double the largest lateral dimension of each magnetic element.

9. A semiconductor chip according to claim 8, wherein the or each magnetic element includes a single magnetic domain.

10. A semiconductor chip according to claim 8 or 9, wherein the lateral dimension of the or each magnetic element is no more than 1 μm.

11. A semiconductor chip according to any of claims 8 to 10, further comprising a layer of refractory metal (12) under the magnetic material (14).

12. A semiconductor chip according to any of claims 8 to 11, further comprising a protection layer (16) above the magnetic material (14).

13. A semiconductor chip according to any of claims 8 to 12, wherein the magnetic material (14) is an alloy of Fe and Ni.

**Patentansprüche**

1. Ein Verfahren zum Anfertigen eines Induktors auf einem Chip, welches aufweist:

Herstellen eines integrierten Schaltungschips (2) auf einem Substrat bis zu einem Schritt bei dem eine Metallisierungsschicht (6) gebildet wird, wobei der integrierte Schaltungchip (2) eine Mehrzahl von Halbleiter Bauelementen (4) enthält;
Definieren eines Loops (30), welcher sich in der Ebene (10) des Chips in der Metallisierungsschicht (6) erstreckt;
Abscheiden einer Schicht von magnetischem Material (14);
Abscheiden und Strukturieren von Resist (18) über der Schicht von magnetischem Material, um die Fläche von zumindest einem magnetischen Element (32) innerhalb des Loops zu definieren;
Ätzen, um das magnetische Material (14) zu entfernen, außer wo es mittels des Resists geschützt ist; und
Entfernen des Resists, um den Loop (30) in der Metallisierungsschicht (6) um zumindest ein magnetisches Element des magnetischen Materials (14) herum zu hinterlassen, wobei das oder jedes magnetische Element (32) seitliche Ausdehnungen hat, so dass es nicht mehr als fünf magnetische Bereiche enthält, wobei die Schritte des Abscheidens und Strukturierens von Resist (18) und des Ätzens eine Mehrzahl von magnetischen Elementen (32) innerhalb des Loops (10) definieren, wobei die magnetischen Elemente voneinander beabstandet sind, um eine Lücke zwischen benachbarten Elementen von zumindest dem Doppelten der größten seitlichen Ausdehnung von jedem magnetischen Element zu haben.

2. Das Verfahren gemäß Anspruch 1, wobei das oder jedes magnetische Element (32) einen einzelnen magnetischen Bereich enthält.

3. Das Verfahren gemäß Anspruch 1 oder 2, wobei die seitliche Ausdehnung von dem oder jedem magnetischen Element (32) nicht mehr als 1 $\mu$m beträgt.

4. Das Verfahren gemäß irgendeinem vorangehenden Anspruch, welches ferner aufweist
Abscheiden einer hitzebeständigen Metallschicht (12) über der Oberfläche des Chips nach dem Schritt des Definierens eines Loops (30) und vor dem Schritt des Abscheidens einer Schicht von magnetischem Material (14), wobei der Schritt des Ätzens auch das hitzebeständige Metall (12) entfernt, außer wo es mittels des Resists (18) geschützt ist.

5. Das Verfahren gemäß irgendeinem vorangehenden Anspruch, welches ferner
Abscheiden einer Schutzschicht (16) über der Schicht von magnetischem Material (14) aufweist, wobei der Schritt des Ätzens auch die Schutzschicht (16) entfernt, außer wo sie mittels des Resists geschützt ist.

6. Das Verfahren gemäß irgendeinem vorangehenden Anspruch, wobei der Schritt des Ätzens eine trockene Chlor Ätzung verwendet.

7. Das Verfahren gemäß irgendeinem vorangehenden Anspruch, wobei das magnetische Material eine Legierung aus Fe und Ni ist.

8. Ein Halbleiterchip, welcher aufweist:

eine Mehrzahl von Halbleiterbauelementen (4), welche auf einem Substrat gebildet sind;
eine Metallisierungsschicht (6) über dem Substrat, wobei die Metallisierungsschicht zumindest einen Loop (30) enthält, welcher einen Induktor formt;
ein magnetisches Material (14), welches als zumindest ein magnetisches Element (32) innerhalb des Loops gebildet ist, wobei das magnetische Element seitliche Ausdehnungen hat, so dass es nicht mehr als fünf magnetische Bereiche enthält,
und welches magnetische Material eine Mehrzahl von magnetischen Elementen (32) innerhalb des Loops (10) enthält, wobei die magnetischen Elemente voneinander beabstandet sind, um eine Lücke zwischen benachbarten Elementen von zumindest dem Doppelten der größten seitlichen Ausdehnung von jedem magnetischen Element zu haben.

9. Der Halbleiterchip gemäß Anspruch 8, wobei das oder jedes magnetische Element einen einzelnen magnetischen Bereich enthält.

10. Der Halbleiterchip gemäß Anspruch 8 oder 9, wobei die seitliche Ausdehnung von dem oder jedem magnetischen Element nicht mehr als 1 $\mu$m beträgt.

11. Der Halbleiterchip gemäß irgendeinem der Ansprüche 8 bis 10, welcher ferner eine Schicht von hitzebeständigem Metall (12) unter dem magnetischen Material (14) aufweist.

12. Der Halbleiterchip gemäß irgendeinem der Ansprüche 8 bis 11, welcher ferner eine Schutzschicht (16) oberhalb des magnetischen Materials (14) aufweist.

13. Der Halbleiterchip gemäß irgendeinem der Ansprüche 8 bis 12, wobei das magnetische Material (14) eine Legierung aus Fe und Ni ist.

**Revendications**

1. Procédé de réalisation d'une inductance sur une puce, comprenant :

la fabrication d'une puce de circuit intégré (2) sur un substrat jusqu'à une étape avec la formation d'une couche de métallisation (6), la puce de circuit intégré (2) comportant une pluralité de dispositifs semi-conducteurs (4) ;
la définition d'une boucle (30) s'étendant dans le plan de la puce (10) dans la couche de métallisation (6) ;
le dépôt d'une couche de matériau magnétique (14) ;
le dépôt et la mise en forme d'une résine photosensible (18) au-dessus de la couche de matériau magnétique de manière à définir la zone d'au moins un élément magnétique (32) à l'intérieur de la boucle ;

la gravure pour éliminer le matériau magnétique (14) sauf lorsque celui-ci est protégé par la résine photosensible ; et

l'élimination de la résine photosensible pour laisser la boucle (30) dans la couche de métallisation (6) autour d'au moins un élément magnétique (32) du matériau magnétique (14), l'élément magnétique ou chacun des éléments magnétiques (32) ayant des dimensions latérales telles qu'il ne contienne pas plus de cinq domaines magnétiques, dans lequel les étapes de dépôt et de mise en forme de la résine photosensible (18) et de gravure définissent une pluralité d'éléments magnétiques (32) à l'intérieur de la boucle (10), les éléments magnétiques étant espacés les uns par rapport aux autres de manière à ce qu'il y ait un intervalle entre des éléments adjacents d'au moins le double de la plus grande dimension latérale de chacun des éléments magnétiques.

2. Procédé selon la revendication 1 dans lequel l'élément magnétique ou chacun des éléments magnétiques (32) contient un seul domaine magnétique.

3. Procédé selon les revendications 1 ou 2 dans lequel la dimension latérale de l'élément magnétique ou de chacun des éléments magnétiques (32) n'est pas supérieure à 1 $\mu$m.

4. Procédé selon l'une quelconque des revendications précédentes, comprenant en outre le dépôt d'une couche de métal réfractaire (12) sur la surface de la puce après l'étape de définition d'une boucle (30) et avant l'étape de dépôt d'une couche de matériau magnétique (14), dans lequel l'étape de gravure élimine également le métal réfractaire (12) sauf lorsque celui-ci est protégé par la résine photosensible (18).

5. Procédé selon l'une quelconque des revendications précédentes, comprenant en outre le dépôt d'une couche de protection (16) au-dessus de la couche de matériau magnétique (14), dans lequel l'étape de gravure élimine également la couche de protection (16) sauf lorsque celui-ci est protégé par la résine photosensible.

6. Procédé selon l'une quelconque des revendications précédentes, dans lequel l'étape de gravure utilise une gravure au chlore à sec.

7. Procédé selon l'une quelconque des revendications précédentes, dans lequel le matériau magnétique est un alliage de Fe et de Ni.

8. Puce de semi-conducteurs, comprenant :

une pluralité de dispositifs semi-conducteurs (4) formés sur un substrat ;

une couche de métallisation (6) sur le substrat, la couche de métallisation comportant au moins une boucle (30) formant une inductance ;

un matériau magnétique (14) formé en tant qu'au moins un élément magnétique à l'intérieur de la boucle (32), l'élément magnétique ayant des dimensions latérales telles qu'il ne contienne pas plus de cinq domaines magnétiques, et contenant une pluralité d'éléments magnétiques (32) à l'intérieur de la boucle (10), les éléments magnétiques étant espacés les uns par rapport aux autres de manière à ce qu'il y ait un intervalle entre des éléments adjacents d'au moins le double de la plus grande dimension latérale de chacun des éléments magnétiques.

9. Puce de semi-conducteurs selon la revendication 8, dans laquelle l'élément magnétique ou chacun des éléments magnétiques contient un seul domaine magnétique.

10. Puce de semi-conducteurs selon les revendications 8 ou 9, dans laquelle la dimension latérale de l'élément magnétique ou chacun des éléments magnétiques n'est pas supérieure à 1 $\mu$m.

11. Puce de semi-conducteurs selon l'une quelconque des revendications 8 à 10, comportant en outre une couche de métal réfractaire (12) sous le matériau magnétique (14).

12. Puce de semi-conducteurs selon l'une quelconque des revendications 8 à 11, comportant en outre une couche de protection (16) au-dessus du matériau magnétique (14).

13. Puce de semi-conducteurs selon l'une quelconque des revendications 8 à 12, dans lequel le matériau magnétique (14) est un alliage de Fe et de Ni.

8

Fig. 1

Fig. 2

8

10

2

6

Fig. 3

30

32

34

Fig. 4

30

32

34

Fig. 5

a

30

32

34

2a

Fig. 6

## REFERENCES CITED IN THE DESCRIPTION

**Patent documents cited in the description**

- US 6441715 B

**Non-patent literature cited in the description**

- **S. RAMO ; J. R. WHINNERY ; T. VANDUZER.** Fields and Waves in Communication Electronics. John Wiley & Sons, Inc, 1994
- **W. R. SMYTHE.** Static and Dynamic Electricity. McGraw-Hill Book Company, 1950
- **N X SUN et al.** *IEEE Tran Magnetic,* 2002, vol. 38 (1), 146
- **L GIOVANNINI et al.** *Phys Rev. B,* 2004, vol. 70, 172404
- **P. WANG et al.** *IEEE Tran Magnetics,* 2009, vol. 45 (1), 71-74